# EUROPEAN PATENT APPLICATION

(11) **EP 2 538 461 A2**
(43) Date of publication of application: **26.12.2012**
(21) Application number: 12159472.5
(22) Date of filing: 14.03.2012
(51) Int. Cl.: H01L 33/50

(54) **Light-emitting module and lighting apparatus**

(30) Priority: 27.05.2011 JP 2011119406
(71) Applicant: Toshiba Lighting & Technology Corporation, Yokosuka-shi Kanagawa 237-8510 (JP)
(72) Inventor: Kawashima, Seiko, Kanagawa, 237-8510 (JP); Oyaizu, Tsuyoshi, Kanagawa, 237-8510 (JP); Betsuda, Nobuhiko, Kanagawa, 237-8510 (JP); Watanabe, Miho, Kanagawa, 237-8510 (JP)
(74) Representative: Willquist, Sofia Ellinor

(57) **Abstract**

Disclosed is a light-emitting module including a light-transmissive substrate (11), an LED chip (12) arranged on one surface of the light-transmissive substrate (11), and a phosphor layer (13) surrounding the LED chip (12). The phosphor layer (13) includes a first phosphor layer (13a) covering one surface of the LED chip (11) and a second phosphor layer (13b) covering the other surface side of the light-transmissive substrate (11) and being continuous with the first phosphor layer (13a).

## Description

### FIELD

Embodiments described herein relate generally to a light-emitting module using a light-emitting element, such as an LED, and a lighting apparatus.

### BACKGROUND

In recent years, a semiconductor light-emitting element, especially a light-emitting element using a light-emitting diode (hereinafter referred to as LED) is developed in various fields as a light source of a bulb-type white LED lamp capable of replacing an incandescent lamp, as a light source of various lighting apparatuses such as a down light and a spot light, or as a light source of a thin television, a liquid crystal display, a cellular phone, a backlight for various information terminals or an indoor or outdoor advertising display. Besides, since long life, low power consumption, resistance to shock, high speed response, high purity display color, miniaturization and the like can be realized, the semiconductor light-emitting element is applied not only for general illumination but also for various industrial fields.

Typical systems for constructing a white LED unit include (1) a 3-LED system, (2) a system of combination of a blue LED + a yellow phosphor (YAG etc.) + (red phosphor) and (3) a system of combination of an ultraviolet LED + blue, green and red phosphors. Among these systems, the system (2) is generally widely used, and is specifically constructed by pouring a phosphor-containing resin into a concave frame, a reflector, or a frame body, provided with an LED chip.

In addition to this, there is also a light-emitting module including a resin-containing phosphor layer directly formed into a convex shape on a substrate reference surface. In these LED elements, the amount of light and the efficiency are improved, and thermal radiation property is required to obtain these improvements. Besides, in a use environment, if the LED element is used as a guide light, an emergency light or the like, heat resistance is also required.

On the other hand, as a problem in an LED bulb or an LED light source with a Zhaga-compliant unit of GX53 or the like, a light distribution angle is considered in addition to the efficiency. Although a method of using a light guide column, a method of using a polyhedral module, or the like is used as a method of widening the light distribution angle, in these methods, the assembly is not simple, and the light distribution angle is limited.

### BRIEF DESCRIPTION OF THE DRAWINGS

FIG. 1A is a vertical sectional view of a light-emitting module of an embodiment.
FIG. 1B is a partial sectional view of an LED chip of the light-emitting module.
FIG. 2 is a vertical sectional view of a lighting apparatus including the light-emitting module.

### DETAILED DESCRIPTION

In general, according to one embodiment, a light-emitting module includes a light-transmissive substrate, an LED chip arranged on one surface side of the light-transmissive substrate, and a phosphor layer surrounding the LED chip. The phosphor layer includes a first phosphor layer covering an upper surface of the LED chip and a second phosphor layer covering the other surface side of the light-transmissive substrate and being continuous with the first phosphor layer.

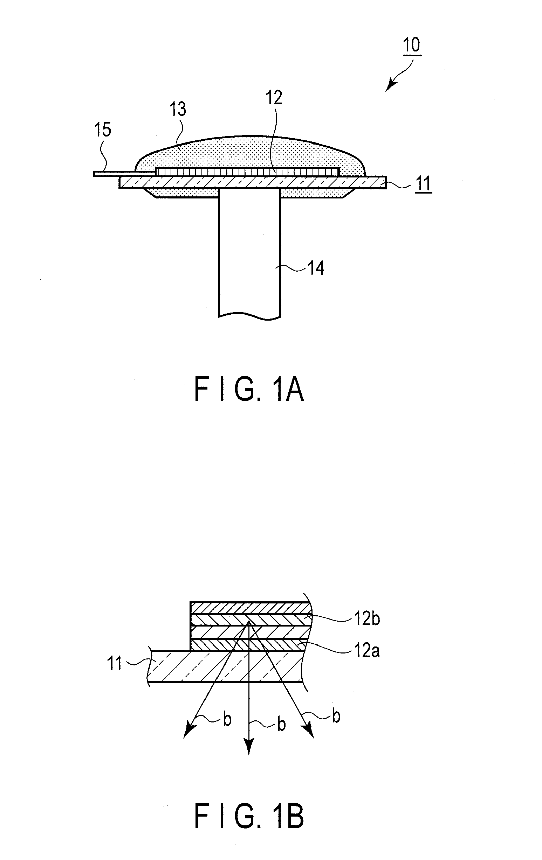

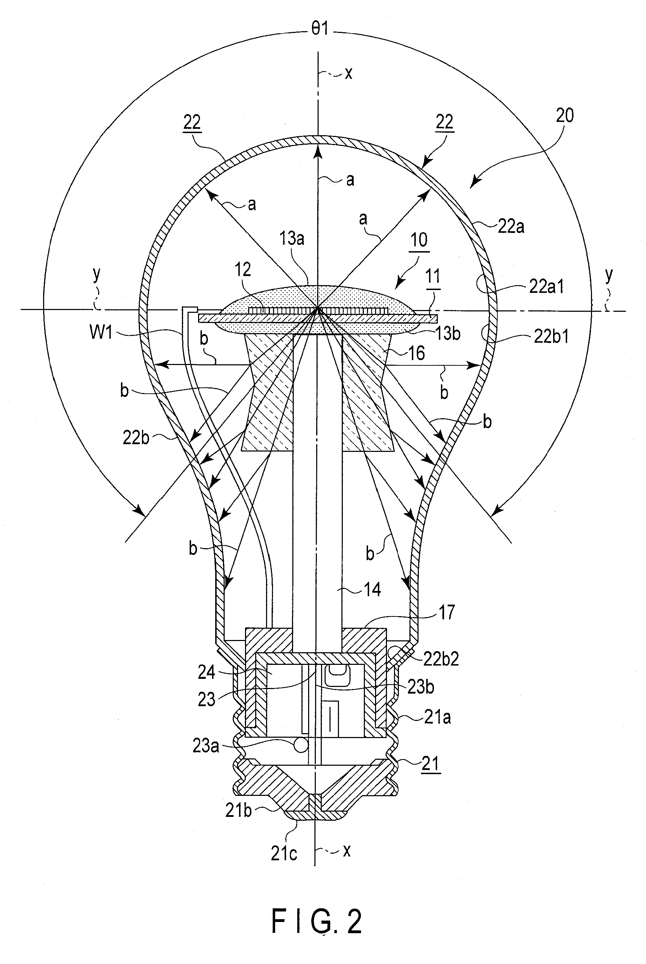

The light-emitting module of the present embodiment is used as a light source of a lighting apparatus including a lamp with a screw base capable of replacing an incandescent lamp for general illumination. FIG. 1A shows a light-emitting module 10, and FIG. 2 shows a structure of a lighting apparatus using the light-emitting module 10 as a light source.

As shown in FIG. 1A, the light-emitting module 10 includes a substrate 11 made of light-transmissive ceramic, a light-emitting element 12 that is arranged on one surface side of the substrate, and emits light from the whole of an upper part, a side part and a lower part, that is, emits light also from the side and the other surface side of the substrate through the light-transmissive ceramic, and a phosphor layer 13 surrounding the light-emitting element 12.

The substrate 11 is formed of, for example, a thin flat plate having a thickness of about 0.5 mm and a substantially square shape. As the light-transmissive ceramic constituting the substrate 11, polycrystalline alumina (PCA), sapphire, aluminum nitride or the like can be used.

A wiring pattern is formed on one surface side (front surface side) of the substrate 11 by screen-printing a metal paste of silver, silver-palladium alloy, gold, copper or the like. At this time, since the substrate 11 is made of ceramic, the substrate has an electrical insulation property. Thus, an electrical insulating treatment including coating with an epoxy based organic resin is not required between the substrate and the wiring pattern. Thus, gas from the organic resin is not released, and a light flux maintenance factor is not reduced in a long life. Besides, advantage is obtained also in cost.

One or plural light-emitting elements 12, in this embodiment, light-emitting diode (hereinafter referred to as LED) chips are bonded to the wiring pattern by using a COB technique and are mounted on the substrate 11 in a substantially matrix form. Besides, the respective LED chips 12 arranged regularly in the substantially matrix form are connected in series to adjacent wiring patterns (not shown) by bonding wires.

As shown in FIG. 1A, a pair of power-supply terminals 15 (only one is shown) constituting an input terminal part respectively extend from the wiring pattern to a side edge of the substrate 11. The respective power-supply terminals 15 include silver (Ag) layers formed on light-transmissive alumina, one of the power-supply terminals functions as a plus side power-supply terminal, and the other functions as a minus side power-supply terminal.

The LED chip 12 of the present embodiment is a blue LED chip with high brightness and high output. As shown in FIG. 1B, the LED chip includes a light-emitting layer 12b laminated on a light-transmissive sapphire substrate 12a. The light-emitting layer 12b is formed into a substantially rectangular parallelepiped shape by sequentially laminating an n-type nitride semiconductor layer, an InGaN light-emitting layer, and a p-type nitride semiconductor layer.

Since the light-transmissive substrate is adopted as the substrate 11, as shown in FIG. 1B, a light "b" (light directed downward in FIG. 1B) emitted from the light-emitting layer 12b of the blue LED chip 12 through the light-transmissive sapphire substrate 12a of the other surface side (back surface side) is guided along an optical axis to the other surface side, that is, in the case of a lamp with a screw base, to the phosphor layer on the back surface side (screw base side) of the lamp, so that the one substrate can have a both side light-emitting function in which a light distribution angle is widened by adding back emission of light. Besides, the light distribution angle can be further widened by adding also side light emission in which light incident into the substrate 11 is guided sideways by refraction and reflection at the interface, passes through the phosphor layer existing at the side and is emitted.

As stated above, the vertically continuous phosphor layer 13 is disposed on the substrate 11 on which the LED chips 12 are arranged, so that the phosphor layer 13 covers the LED chips 12 on the front surface side and covers the back surface of the substrate 11 on the other surface side. That is, the LED chips 12 are arranged at the center of an area surrounded by the phosphor layer 13 and are put in a state of being surrounded by the phosphor layer 13. As a result, the light-emitting module emits light in all directions, that is, the whole emits light. Besides, since the LED chips 12 are mounted on the substrate 11, the mounting can be easily performed.

The phosphor layer 13 allows the blue light emitted from the LED chips 12 to pass through, and the blue light excites the yellow phosphor and is converted into yellow light. The transmitted blue light and the yellow light are mixed with each other, and white light is emitted.

The phosphor layer 13 is produced by dispersing and mixing, for example, yellow phosphor into transparent resin, for example, silicone resin, and is formed by, for example, coating. Alternatively, there is also a method using a molding machine or a forming method using dipping.

As shown in FIG. 2, the phosphor layer 13 includes a first phosphor layer 13a covering the LED chips 12 on one surface side of the substrate 11, and a second phosphor layer 13b covering the back surface of the substrate 11 on the other surface (back surface) side. The first phosphor layer 13a and the second phosphor layer 13b are continuous with each other on the side part of the substrate 11. In this case, although the first phosphor layer 13a and the second phosphor layer 13b may be continuous with each other on all peripheral edge parts, the first phosphor layer and the second phosphor layer may be continuous only on a part. For example, since four corners of the substrate 11 are used as support parts, the first phosphor layer 13a and the second phosphor layer 13b may be discontinuous with each other on the four corners. That is, FIG. 1A and FIG. 2 show a section taken in the diagonal direction of the rectangular substrate 11, and only the four corners of the substrate 11 are not covered with the phosphor layer, but are exposed.

As stated above, since the phosphor layer 13 is continuous in the vertical direction, the phosphor layer 13 exists also on the side part of the substrate 11, and the reduction of the amount of light in the lateral direction is prevented. If the phosphor layer 13 does not exist on the side part of the substrate 11, the blue light from the LED chip 12 is directly emitted without passing through the phosphor layer 13, and therefore, the amount of light in the lateral direction is reduced.

The phosphor layer 13 may have a spherical shape, that is, the thickness of the first phosphor layer 13a may be equal to that of the second phosphor layer 13b. However, as shown in FIG. 1A and FIG. 2, the phosphor layer is formed into a shell shape, and the thickness of the first phosphor layer 13a may be made different from that of the second phosphor layer 13b. In this case, the thickness of the first phosphor layer 13a is desirably made thicker than that of the second phosphor layer 13b. The reason is as follows.

When the blue light emitted from the LED chip 12 passes through the substrate 11, the amount of light is reduced by about 10% according to the transmittance as compared with the light direction upward. Thus, if the first phosphor layer 13a and the second phosphor layer 13b have the same thickness (light path length), a color temperature shift occurs between the upper and lower parts, and a color temperature difference of as high as 200K occurs.

On the other hand, if the phosphor layer 13 surrounding the LED chips 12 is not made spherical but made, for example, shell-shaped, and the thickness of the first phosphor layer 13a is made thicker than the thickness of the second phosphor layer 13b, the color temperature difference between the upper and lower parts can be eliminated. In order to reduce the color temperature difference between the upper and lower parts to, for example, about 50K, the thickness of the first phosphor layer 13a is desirably made 105% to 108% of that of the second phosphor layer 13b.

Besides, for example, a circular opening is formed in a part of the second phosphor layer 13b on the back surface of the substrate 11, and that part of the back surface of the substrate 11 can be exposed. If the substrate is fixed to a heat pipe 14 at the exposed part, excellent contact with the metal member and firm fixation can be realized. Incidentally, the substrate may be fixed to a housing, a heat sink or the like instead of the heat pipe 14. Reduction in heat resistance and improvement in efficiency can be realized by ensuring the thermal radiation path as stated above.

As described above, in the light-emitting module of the embodiment, since the phosphor layer 13 is formed so as to surround the LED chips 12, the light directed sideways also passes through the phosphor layer 13 and the white light is emitted. Thus, if the amount of light directed sideways is made large, the whole uniformly emits light. As a unit configured to increase the amount of light directed sideways, there is a unit in which the refractive index of the substrate 11 is made larger than that of the transparent resin contained in the phosphor layer 13.

The refractive index of silicone resin as the transparent resin is 1.4, the refractive index of sapphire as the light-transmissive ceramic of the substrate 11 is 1.7, and the refractive index of air is 1.0. If the refractive indexes of these are the same, the light emitted from the LED chip 12 travels straight, and the light in the lateral direction of the substrate is not generated. However, if there is a difference in the refractive index, when the light reaches an interface where the refractive index varies, the light is refracted. Especially, when the light passing through the sapphire substrate 11 of the LED chip 12 reaches the silicone resin as the surrounding material, the light is refracted, and the whole phosphor layer in which phosphor particles are dispersed in the silicone resin emits light.

Besides, when the light passes through the sapphire as the light-transmissive ceramic of the substrate 11 from the silicone resin surrounding the LED chips 12, since the refractive index of the sapphire is significantly larger than that of the silicone resin, the light travels also in the lateral direction, and the whole emits light. If the difference in the refractive index is small, the light is not emitted in the lateral direction of the substrate and the light becomes dim.

The difference between the refractive index of the light-transmissive ceramic constituting the substrate 11 and the refractive index of the transparent resin surrounding the LED chips 12 is preferably 0.1 to 0.4. If the difference is less than 0.1, the effect obtained by providing the difference in the refractive index is hardly obtained, and the amount of light directed sideways is small. If the difference exceeds 0.4, the amount of light directed sideways becomes excessively large, and the amount of light in the up and down direction is reduced. Incidentally, the refractive index is based on the sodium D line wavelength of 589.3 nm.

Although the first phosphor layer 13a and the second phosphor layer 13b are continuous on the side of the substrate 11 as described above, the phosphor layers may not be continuous on all peripheral parts but may be continuous only on a part. In this case, in the discontinuous portion, since the blue light from the LED chip 12 is directly emitted without passing through the phosphor layer 13, there is a problem that the amount of light in the lateral direction is reduced. In this case, for example, the light from the LED chip 12 is totally reflected at the surface of the substrate 11, and the light is released in the lateral direction, or the light entering the substrate 11 is totally reflected at the lower surface of the substrate 11, and the light is released in the lateral direction. Thus, the amount of light directed sideways becomes large.

As a unit configured to prevent this problem, there is a means for roughening the surface of the substrate 11 to form an uneven surface. If the surface of the substrate 11 is made the uneven surface, light releasing in the lateral direction is reduced, and uniform light traveling upward and downward is obtained. As a result, the excellent efficiency and light distribution angle can be obtained. Besides, if the surface of the substrate 11 is made the uneven surface, excellent adhesiveness between the substrate 11 and the LED chip 12 is obtained, and the effect of improvement in reliability is also obtained.

A surface roughness Ra is preferably 0.5 to 5.0. If the surface roughness Ra is less than 0.5, the effect is hardly obtained. If the surface roughness exceeds 5.0, the light is scattered by the uneven surface, the efficiency of extracting the light is reduced and the efficiency is reduced, which is not preferable.

Methods of roughening the surface of the substrate 11 include sand brushing, a chemical treatment method, and a method of molding ceramics by a mold having an uneven surface.

In the above-described example, although the phosphor layer 13 is formed to be in direct contact with and to cover the LED chip 12, no limitation is made to this form. The phosphor layer can be formed to be spaced from and to surround the LED chip 12. Also by this, the same effect as the effect obtained when the phosphor layer is formed to be in direct contact with and to cover the LED chip can be obtained. That is, the light-emitting module emits light in all directions, that is, the whole emits light.

Incidentally, in this case, if there is a space between the LED chip 12 and the phosphor layer, the LED chip 12 is deteriorated by the air. Accordingly, the space is required to be filled with a transparent sealing resin.

Next, a structure of a lighting apparatus using the light-emitting module 10 constructed as described above as a light source will be described. The lighting apparatus of the present embodiment is a lamp 20 with a screw base capable of replacing an incandescent lamp for general illumination. As shown in FIG. 2, the lighting apparatus includes the light-emitting module 10, an electric connection part 21 that supports the light-emitting module 10 and supplies power to the light-emitting module 10, a light-transmissive cover member 22 provided to cover the light-emitting module 10, and a lighting device 23 to light the light-emitting module 10.

The electric connection part 21 supports the light-emitting module 10, and supplies power to the light-emitting module 10. In this embodiment, as shown in FIG. 2, the electric connection part 21 is composed of an Edison type E26 screw base. The screw base 21 includes a helical cylindrical copper shell part 21a, and a conductive eyelet part 21c provided at a top of a lower end of the shell part through an electric insulation part 21b.

The light-emitting module 10 and the cover member 22 are supported at an opening of the shell part 21a. That is, a cylindrical support member 17 of the light-emitting module is fitted in the opening of the shell part 21a, and a gap between an outer peripheral surface of the support member 17 and an inner surface of the shell part 21a is filled with an adhesive having heat conductivity, such as silicone resin or epoxy resin, so that the whole light-emitting module 10 is supported by the screw base 21 as the electric connection part. At the same time, heat generated from the LED chip 12 is conducted from the heat pipe 14 through the support member 17 to the shell part 21a, that is, the screw base 21, and can be efficiently radiated to the outside. Incidentally, a concave for receiving the after-mentioned lighting device 23 is formed inside the support member 17.

The light-transmissive cover member 22 provided to cover the light-emitting module 10 constitutes a globe of the lamp, and is made of a material such as, for example, thin glass or synthetic resin. The material is transparent or is semitransparent and exhibits, for example, milky white color and a light diffusion property. In this embodiment, the cover member is made of milky polycarbonate (PC) resin. The cover member 22 of the present embodiment is divided into two parts, that is, an upper cover part 22a to mainly cover a light-emitting part A of the light-emitting module 10 and a lower cover part 22b to mainly cover a light guide 16, whereby a light-emitting area is increased. A dividing line of the upper cover part 22a and the lower cover part 22b is a horizontal line substantially passing through the light-emitting part A of the light-emitting module 10. In other words, the division into two parts is performed along a line y-y substantially perpendicular to an optical axis x-x in the vicinity of a maximum diameter part of the globe.

The upper cover part 22a has a substantially hemispherical shape having an opening 22a1 opened downward, and the hemispherical shape is a smooth curved shape approximated to the silhouette of a ball portion of a general incandescent lamp. The lower cover part 22b includes an upper opening 22b1 coincident with the opening 22a1 of the upper cover part 22a, and a lower opening 22b2 having a small diameter. The outside surface of the lower cover part is smoothly curved downward, so that the outer appearance becomes a shape similar to the silhouette of a neck part of the incandescent lamp for general illumination. Incidentally, abutting surfaces of the openings 22a1 and 22b1 are fixed and integrated by ultrasonic welding or the like, and the upper cover part 22a and the lower cover part 22b are constituted as one globe. The lower opening 22b2 having the small diameter of the lower cover part 22b is fitted to the opening of the shell part 21a of the screw base 21, and is fixed and supported by an adhesive having heat resistance, such as silicone resin or epoxy resin.

As shown in FIG. 2, the lighting device 23 includes a circuit component 23a constituting a lighting circuit of the LED chip 12 in the light-emitting module 10, and a circuit board 23b on which the circuit component is mounted. The lighting circuit is configured to convert an AC voltage of 100 V into a DC voltage of about 3.1 V and supplies a constant DC current to the LED chip 12. The circuit board 23b is made of a reed-shaped glass epoxy member, and small electric parts are mounted on one side or both sides.

The lighting device 23 is housed in the shell part 21a of the screw base 21 and is supported. That is, the circuit board 23b is placed in the vertical direction, an upper portion is inserted in a hollow of a holder 24 made of synthetic resin such as polybutylene terephthalate (PBT), and a lower portion from a middle portion is arranged in the shell part 21a and is supported.

The holder 24 supporting the circuit board is fitted to the concave part of the cylindrical support member 17 and is supported. The lighting device 23 is housed in the screw base 21 in a state where electrical insulation is realized. Incidentally, fixing may be performed by filling spaces between the circuit board 23b and the holder 24, between the holder and the concave part of the support member and between the inner surface of the shell part 21a and the circuit board 23b with an adhesive having heat resistance, heat conductivity and electrical insulation, such as silicone resin or epoxy resin.

As described above, the bulb-type lamp with the screw base is constructed similarly to the incandescent lamp for general illumination. The lamp includes the PS-shaped cover member 22 extending from the front side of the top to the side peripheral surface and formed into a globe shape to increase the light-emitting area, and the E26 screw base 21 provided at the bottom end of the cover member 22, and has the whole outer appearance similar to the silhouette of the incandescent lamp for general illumination.

Next, an operation of the lamp 20 with the screw base constructed as described above will be described. As shown in FIG. 2, when power is supplied to the lamp 20 with the screw base through the screw base 21 and the lamp is lighted, a light "a" is emitted from the light-emitting layer 12b of the blue LED chip 12 of the light-emitting module 10 toward one surface side. The light "a" passes through the yellow phosphor of the first phosphor layer 13a in the light-emitting part A having a substantially square surface shape to convert into white light, is emitted to the inner surface of the upper cover part 22a, passes through the upper cover part, and irradiates outward mainly from the front side of the top.

Besides, a light "b" (light directed downward in FIG. 1B, FIG. 2) emitted from the light-emitting layer 12b of the blue LED chip 12 through the light-transmissive sapphire substrate 12a at the other side (back side) of the chip passes through the substrate 11 made of light-transmissive alumina, and passes through the second phosphor layer 13b to be converted to white light. The white light is guided to the other surface side, that is, the back side (the screw base 21 side) of the lamp 20 with the screw base along the optical axis x-x direction by the light guide 16, is refracted and diffused in the light guide 16 having a cylindrical drum shape, is emitted from the outer peripheral part of the light guide 16 to the inner surface of the lower cover member 22b, passes through the lower cover member, and mainly irradiates outward from the side peripheral surface.

Incidentally, the light directed sideways from the blue LED chip 12 also passed through the phosphor layer to be converted into white light and is emitted sideways.

By this, similarly to the incandescent lamp for general illumination, back emission of light with a wide light distribution angle θ1 can be performed, so that the substantial whole extending from the front side to the back surface through the side peripheral surface uniformly emits light. The illumination having a desired luminous intensity distribution characteristic similar to the incandescent lamp for general illumination can be performed.

At this time, since the heat pipe 14 is provided along the optical axis x-x as the center axis of the bulb, the light "b" emitted from the outer peripheral part of the light guide 16 to the inner surface of the lower cover member 22b is hardly blocked by the heat pipe 14, and the light extraction efficiency can be improved. At the same time, even if there is a partial shading, since the shading is uniformly dispersed to the periphery, uneven color hardly occurs.

At the same time, when the lamp with the screw base is lighted, the temperature of the LED chip 12 rises, and heat is generated. The heat is conducted from the substrate 11 made of the light-transmissive alumina having high heat conductivity to the heat pipe 14 made of copper or aluminum having excellent heat conductivity, and is further conducted to the support member 17 having a fixed lower part of a heat conductive member and made of copper or aluminum. Further, the heat is conducted to the screw base 21 made of copper having excellent heat conductivity, and is radiated to the outside through an equipment-side socket similarly made of copper. In order to raise the heat conductivity from the socket to an equipment, a socket outer member is made of heat conductive ceramic or resin. The thermal radiation operation is always continuously performed during lighting, so that reduction in light-emitting efficiency of the LED chip 12 can be suppressed.

Besides, since the circuit board 23b of the lighting device 23 is supported by filling the screw base 21 with the adhesive having excellent heat conductivity, the heat of the built-in circuit board 23b is also diffused by the adhesive, and is radiated to the outside through the shell part 21a made of copper. Thus, temperature rise of the circuit component 23a can also be suppressed, and the reliability of electronic components can also be raised. By the above operation and by forming the substrate using the light-transmissive alumina having high purity and high heat conductivity, the light-emitting module and the lighting apparatus, in which the light-emitting efficiency is raised and the desired luminous intensity distribution can be obtained, can be constructed.

Next, with respect to various specific embodiments, comparison tests among examples, related art examples and reference example were performed.

### First Embodiment

This embodiment discloses a light-emitting module in which a light-transmissive substrate is used to support an LED chip, and a phosphor layer containing phosphor particles dispersed in a transparent resin is arranged to surround the LED chip.

A light-transmissive alumina (PCA) substrate having a purity of 99.6% and cut into the regulation size was used as the light-transmissive substrate. A wiring layer was formed by screen-printing a metal paste on the PCA substrate and by performing firing and fixing. Next, one or plural LED chips, for example, 100 LED chips were mounted on the PCA substrate on which the wiring layer was formed, and were bonded to the wiring layer by a gold wire having a thickness of 25 microns. Although the surface of the light-transmissive alumina having high purity was smooth, a bad influence was not given to the chip bonding property, and there was no problem in manufacture.

Next, six kinds of samples different in the forming method of the phosphor layer were formed.

Related art example 1: After a bank surrounding the LED chips was formed on the PCA substrate, a phosphor-containing resin was poured and was hardened to form a phosphor layer covering the upper surfaces of the LED chips. Besides, after a bank surrounding an area corresponding to the LED chips was formed also on the back surface of the PCA substrate, a phosphor-containing resin was poured and was hardened to form a phosphor layer covering the lower part of the LED chips.

Related art example 2: After a bank surrounding the LED chips was formed on the PCA substrate, a phosphor-containing resin was poured and was hardened to form a phosphor layer covering the upper surfaces of the LED chips. Besides, a phosphor sheet was arranged in that area of the back surface of the PCA substrate which corresponds to the LED chips.

Example 1: A spherical phosphor layer covering the upper surfaces of the LED chips and continuously covering the back surface of the PCA substrate was formed by a molding machine.

Example 2: A shell-shaped phosphor layer covering the upper surfaces of the LED chips and continuously covering the back surface of the PCA substrate was formed by a molding machine.

Examples 3, 4: A shell-shaped phosphor layer covering the upper surfaces of the LED chips and continuously covering the back surface of the PCA substrate was formed by a molding machine, and a circular exposed part was provided in the phosphor layer at the center of the back surface of the substrate.

With respect to the above respective samples, an electric current was made to flow to emit light, and the amount of light of the side surface, the light distribution angle, efficiency and the light color temperature difference were measured. Incidentally, with respect to the samples of the examples 3 and 4, the ratio of substrate heat resistance to that of the sample of the example 2 was measured.

The results are shown in Table 1 and Table 2.

**Table 1**

| | Related art example 1 | Related art example 2 | Example 1 | Example 2 |
|---|---|---|---|---|
| Material of substrate | light-transm issive alumina | light-transm issive alumina | light-transm issive alumina | light-transm issive alumina |
| Grade | 99.6% | 99.6% | 99.6% | 99.6% |
| Heat conductivity (w/mk) | 33 | 33 | 33 | 33 |
| Phosphor layer | upper pouring lower pouring | upper pouring lower sheet | molding spherical shape | molding shell |
| Light amount of side surface | 55% | 55% | 65% | 70% |
| Light distribution angle (degree) | 300 | 300 | 340 | 340 |
| Efficiency (%) (5000K)* | 102 | 100 | 104 | 106 |
| Substrate position | Inside | inside | inside | inside |
| Light color temperature difference | - | - | 200K | 50K |

| | | | | |
|---|---|---|---|---|
| *: relative to general alumina 96% | | | | |

**Table 2**

| | Example 3 | Example 4 |
|---|---|---|
| Material of substrate | light-transmi ssive alumina | light-transmi ssive alumina |
| Grade | 99.6% | 99.6% |
| Heat conductivity (w/mk) | 33 | 33 |
| Phosphor layer | molding shell | molding shell |
| Light amount of side surface | 70% | 70% |
| Light distribution angle (degree) | 340 | 340 |
| Efficiency (%) (5000K)* | 107 | 108 |
| Substrate position | partially exposed | partially exposed |
| Substrate housing fixation | middle | reinforcement |
| Light color temperature difference | 50K | 50K |
| Heat resistance of substrate (relative to the example 2) | -10% | -20% |

| | | |
|---|---|---|
| *: relative to general alumina 96% | | |

From Table 1, it is understood that in the light-emitting modules of the example 1 and the example 2 in which the phosphor layer is formed into the spherical shape or the shell shape so as to cover the periphery of the LED chips, the amount of light of the side surface is greatly increased as compared with the light-emitting modules of the related art examples 1, 2 and 3 in which the side part is not covered with a phosphor layer. Besides, the light distribution angle was increased from 300° to 340°, and the efficiency was also slightly increased. Incidentally, the light color temperature difference of the shell-shaped phosphor layer was smaller than that of the spherical phosphor layer of the example 1.

Besides, from Table 1 and Table 2, in the examples 3 and 4 in which the back surface of the substrate was partially exposed, the substrate could be firmly fixed to a metal housing, a heat pipe or a heat sink, and a thermal radiation path was ensured. Thus, the heat resistance was reduced, and consequently, the efficiency was also improved.

### Embodiment 2

Five kinds of samples were prepared by the same method as the embodiment 1 except that refractive indexes of a light-transmissive substrate and a transparent resin material of a phosphor layer were variously changed as described below.

Reference example 1: Silicone resin was used as the light-transmissive substrate, and silicone rubber was used as the transparent resin material.

Reference example 2: Glass was used as the light-transmissive substrate, and silicone rubber was used as the transparent resin material.

Example 5: Light-transmissive alumina was used as the light-transmissive substrate, and silicone rubber was used as the transparent resin material.

Example 6: Sapphire was used as the light-transmissive substrate, and silicone rubber was used as the transparent resin material.

Reference example 3: High refractive index glass was used as the light-transmissive substrate, and silicone rubber was used as the transparent resin material.

With respect to the above respective samples, an electric current was made to flow to emit light, and the amount of light of the side surface, the light distribution angle, and efficiency were measured.

The results are shown in Table 3.

**Table 3**

| | Reference example 1 | Reference example 2 | Example 5 | Example 6 | Reference example 3 |
|---|---|---|---|---|---|
| Chip surrounding Material | silicone rubber | silicone rubber | silicone rubber | silicone rubber | silicone rubber |
| Grade | 99.6% | 99.6% | 99.6% | 99.6% | 99.6% |
| Refractive index | 1.41 | 1.41 | 1.41 | 1.41 | 1.41 |
| Material of substrate | silicone resin | quartz glass | light-trans missive alumina | sapphire | high refractive index glass |
| Refractive index | 1.41 | 1.45 | 1.75 | 1.75 | 1.90 |
| Phosphor layer | molding shell | molding shell | molding shell | molding shell | molding shell |
| Light amount of side surface | 38% | 40% | 65% | 70% | 89% |
| Light distribution angle (degree) | 260 | 260 | 340 | 340 | 280 |
| Efficiency (%) (5000K)* | 102 | 102 | 104 | 106 | 102 |

| | | | | | |
|---|---|---|---|---|---|
| *: relative to general alumina 96% | | | | | |

From Table 3, it is understood that when the material having the higher refractive index than the transparent resin material covering the periphery of the LED chips is used as the light-transmissive substrate, especially in the samples of the examples 5 and 6 in which the refractive index difference is 0.1 to 0.4, all of the amount of light of the side surface, the light distribution angle and the efficiency are increased.

On the other hand, in the samples of the reference examples 1 and 2 in which the refractive index difference between the light-transmissive substrate and the transparent resin material is less than 0.1, all of the amount of light of the side surface, the light distribution angle and the efficiency are lower than those of the samples of the examples 5 and 6. Besides, in the sample of the reference example 3 in which the refractive index difference between the light-transmissive substrate and the transparent resin material exceeds 0.4, since the amount of light of the side surface is excessively large, the light distribution angle and the efficiency are lower than those of the samples of the examples 5 and 6.

### Embodiment 3

Surface roughness of a light-transmissive substrate was variously changed as described below, and three samples were prepared by the same method as the embodiment 1.

Reference example 4: Light-transmissive alumina having a surface roughness of 0.4 was used as the light-transmissive substrate, and silicone rubber containing phosphor was used as a chip surrounding material.

Example 7: Light-transmissive alumina having a surface roughness of 0.5 was used as the light-transmissive substrate, and silicone rubber containing phosphor was used as a chip surrounding material.

Example 8: Light-transmissive alumina having a surface roughness of 1.5 was used as the light-transmissive substrate, and silicone rubber containing phosphor was used as a chip surrounding material.

With respect to the above respective samples, an electric current was made to flow to emit light, and the adhesiveness between the substrate and the LED chip, the amount of light of the side surface, the light distribution angle, and the efficiency were measured.

The results are shown in Table 4.

**Table 4**

| | Reference example 4 | Example 7 | Example 8 |
|---|---|---|---|
| Chip surrounding material | silicone | Silicone | silicone |
| Whether or not containing phosphor | containing phosphor | containing phosphor | containing phosphor |
| Material of substrate | light-transmis sive alumina 99.6% | light-transmis sive alumina 99.6% | light-transmis sive alumina 99.6% |
| Surface roughness | 0.4 | 0.5 | 1.5 |
| Adhesiveness | slightly inferior | good | excellent |
| Phosphor layer | molding shell | molding spherical shape | molding shell |
| Amount of light of side surface | 60% | 70% | 75% |
| Light distribution angle (degree) | 290 | 320 | 340 |
| Efficiency (%) (5000K) * | 102 | 102 | 102 |

| | | | |
|---|---|---|---|
| *: relative to general alumina 96% | | | |

From Table 4, it is understood that in the samples of the examples 7 and 8 in which the light-transmissive alumina having a surface roughness of 0.5 to 5.0 is used as the light-transmissive substrate, the adhesiveness between the substrate and the LED chip is excellent, and all of the amount of light of the side surface, the light distribution angle and the efficiency are increased.

On the other hand, in the sample of the reference example 4 in which the light-transmissive alumina having a surface roughness of less than 0.5 is used as the light-transmissive substrate, the adhesiveness between the substrate and the LED chip is slightly inferior, and both the amount of light of the side surface and the light distribution angle are lower than those of the samples of the examples 7 and 8.

### Embodiment 4

LED chips were surrounded by a phosphor-containing transparent resin material and a transparent resin material not containing phosphor, a spherical or shell-shaped phosphor layer was formed around the transparent resin material not containing phosphor, and three kinds of samples were prepared by the same method as the embodiment 1.

Reference example 5: A shell-shaped phosphor layer made of the phosphor-containing transparent resin material was formed to surround the LED chips.

Example 9: The LED chips were surrounded with the transparent resin material not containing phosphor, and the spherical phosphor layer was formed therearound.

Example 10: The LED chips were surrounded with the transparent resin material not containing phosphor, and the shell-shaped phosphor layer was formed therearound.

With respect to the above respective samples, an electric current was made to flow to emit light, and the amount of light of the side surface, the light distribution angle and the efficiency were measured.

The results are shown in Table 5.

**Table 5**

| | Reference example 5 | Example 9 | Example 10 |
|---|---|---|---|
| Chip surrounding material | silicone | silicone | silicone |
| Whether or not containing phosphor | containing phosphor | no phosphor | no phosphor |
| Material of substrate | light-transmissive alumina 99.6% | light-transmissive alumina 99.6% | light-transmissive alumina 99.6% |
| Phosphor layer | molding shell | molding spherical shape | molding shell |
| Amount of light of side surface | 75% | 65% | 70% |
| Light distribution angle (degree) | 340 | 340 | 340 |
| Efficiency (%) (5000K) * | 102 | 102 | 102 |

| | | | |
|---|---|---|---|
| *: relative to general alumina 96% | | | |

From Table 5, it is understood that even if the phosphor layer is arranged to be spaced from the LED chips, the same light distribution angle and the same efficiency as those of the case where the phosphor layer is arranged to contact the LED chips can be obtained.

Although the preferable embodiments have been described, the invention is not limited to the respective embodiments described above, and various design changes can be made within the scope not departing from the gist of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light-emitting module comprising a light-transmissive substrate, an LED chip arranged on one surface side of the light-transmissive substrate, and a phosphor layer,
**characterized in that** the phosphor layer (13) includes a first phosphor layer (13a) covering one surface of the LED chip (12) and a second phosphor layer (13b) covering the other surface side of the light-transmissive substrate (11) and being continuous with the first phosphor layer (13a).

2. The module according to claim 1, **characterized in that** the first phosphor layer (13a) is thicker than the second phosphor layer (13b).

3. The module according to claim 1 or 2, **characterized in that** a part of the light-transmissive substrate (11) is exposed from the phosphor layer (13).

4. The module according to claim 3, **characterized in that** a heat pipe (14) for thermal radiation is attached to that portion of the light-transmissive substrate (11) which is exposed from the phosphor layer (13).

5. The module according to any one of claims 1 to 4, **characterized by** further comprising a unit configured to prevent a reduction in an amount of light directed sideways.

6. The module according to claim 5, **characterized in that** the unit is configured to cause a refractive index of the substrate (11) to be larger than that of a transparent resin contained in the phosphor layer (13).

7. The module according to any one of claims 1 to 6, **characterized in that** a surface of the substrate (11) is an uneven surface.

8. The module according to any one of claims 1 to 7, **characterized in that** the phosphor layer (13) is arranged to be spaced from the LED chip (12).

9. The module according to claim 8, **characterized in that** a transparent sealing resin is interposed between the phosphor layer (13) and the LED chip (12).

10. A lighting apparatus **characterized by** comprising a light-emitting module recited in any one of claims 1 to 9.
